# NEUE EUROPÄISCHE PATENTSCHRIFT

(11) **EP 0 185 692 B2**
(45) Veröffentlichungstag und Bekanntmachung des Hinweises auf die Entscheidung über den Einspruch: **02.06.1993**
(45) Hinweis auf die Patenterteilung: 03.05.1989
(21) Anmeldenummer: 85902526.4
(22) Anmeldetag: 17.05.1985
(51) Int. Cl.: G11B 20/18, H04N 5/94, H03G 3/34

(54) **VERFAHREN ZUR VERRINGERUNG DER WARNEHMBARKEIT VON FEHLERN IN EINEM DIGITALEN AUDIOSIGNAL**
PROCESS FOR REDUCING THE NOTICEABILITY OF ERRORS IN A DIGITAL AUDIO SIGNAL
PROCEDE POUR DIMINUER LA RECEPTIVITE AUX ERREURS DANS UN SIGNAL AUDIO NUMERIQUE

(30) Priorität: 01.06.1984 DE 3420516; 15.01.1985 DE 3501087
(43) Veröffentlichungstag der Anmeldung: 02.07.1986
(73) Patentinhaber: TELEFUNKEN Fernseh und Rundfunk GmbH, 30453 Hannover (DE)
(72) Erfinder: ROWEDDA, Volker, D-3017 Pattensen (DE); PLATTE, Hans-Joachim, D-3005 Hemmingen 4 (DE)
(74) Vertreter: Einsel, Robert, Dipl.-Ing.
(86) Internationale Anmeldenummer: EP8500232
(87) Internationale Veröffentlichungsnummer: WO8505723

(56) Entgegenhaltungen:
- EP-A- 0 046 231
- EP-A- 0 047 386
- DE-A- 2 726 707
- DE-A- 2 916 973
- DE-A- 3 304 049
- Electronic Letters, Band 12, Nr. 25, Dezember 1976, Hitchin (GB), M.R. Sach et al.: "Audio-disc scratch filter", pp. 656, 657
- Patents Abstracts of Japan, Band 8, Nr. 101, 12. Mai 1984, p. P-273, 1538 & JP-A-5911511 (AKAI) 21 January 1984

## Beschreibung

Bei der Übertragung oder Speicherung eines digitalen Audiosignals treten statistisch verteilt auch solche Störungen auf, die trotz Fehlerkorrektureinrichtungen bei der Wiedergabe stark hörbar werden können.

Es sind Verfahren und Schaltungen bekannt, die bei Aufzeichnung zusätzlicher Prüf- und Korrekturbits aus dieser Redundanz eine Korrektur oder eine Verdeckung von erkannten Fehlern der digitalen Aufzeichnungs- oder Übertragungstechnik ermöglichen. Derartige Fehlerkorrekursysteme oder Fehlerverdeckungsalgorithmen versagen jedoch meist, wenn die Störung eine bestimmte Dauer überschreitet. Für diesen Fall wird in der Regel eine elektronisch gesteuerte Stummschaltung aktiviert, die für die Dauer des nichtkorrigierbaren Fehlers, die sogenannte Fehlerzeit, das Signal austastet oder- wie man auch sagt - stummschaltet.

Eine derartige Stummschaltung dient im wesentlichen nur dem Schutz der nachfolgenden elektroakustischen Komponenten und dem Schutz des Gehörs des Benutzers, weil bei einer digitalen Übertragung im Falle einer Störung Ausgangssignale mit maximaler Amplitude auftreten können. Der eigentliche Fehler kann durch eine Stummschaltung nicht verdeckt werden. Beim Einsatz einer derartigen Stummschaltung bei der Wiedergabe ist eine HiFi-Qualität nicht mehr gegeben.

Es ist auch bekannt, bei Auftreten eines unkorrigierbaren Fehlers in dem Signal während der Fehlerzeit ein Ersatzsignal aus einem anderen Zeitabschnitt, insbesondere aus einem vorangehenden Zeitabschnitt, einzufügen. Diese Lösung erfordert bei jedem Fehler eine zweifache Umschaltung zwischen dem Weg des Nutzsignals und dem Weg des Ersatzsignals. Außerdem sind zusätzliche Schaltungsmittel erforderlich, um das Ersatzsignal zur Verfügung zu stellen.

Ein Verfahren nach dem Oberbegriff des Anspruchs 1 ist aus « Electronic Letter », 09.12.76, Band 12, Nr. 25, bekannt. Es wird bei dem bekannten Verfahren ein festes Intervall ausgeblendet, wobei die Schnittstellen des Anfangs und des Endes des Intervalls vor oder nach den tatsächlichen Grenzen der Störung liegen. Handelt es sich um kurze, aufeinanderfolgende Störungen, so treten unnötig lange Zeitbereiche auf, in denen kein Signal übertragen wird. Handelt es sich dagegen um eine Störung, die länger als das feste Intervall andauert, so wird ein Teil der Störung trotz der Ausblendung des Signalabschnittes wiedergegeben. Beide Arten von Störungen können also zu wahrnehmbaren Fehlern im wiedergegebenen Signal führen. DE-A-29 169 73 zeigt eine derartige Zusammenziehung im digitalen Signalweg.

Der Erfindung liegt die Aufgabe zugrunde, ein Verfahren zur Verringerung der Wahrnehmbarkeit von unkorrigierbaren Fehlern in einem digitalen Audiosignal zu schaffen, das möglichst ohne hörbare Störungen arbeitet.

Diese Aufgabe wird durch die im Anspruch 1 beschriebene Erfindung gelöst. Vorteilhafte Weiterbildungen der Erfindung sind in den Unteransprüchen beschrieben.

Bei der erfindungsgemäßen Lösung wird der Signalabschnitt, in dem das Signal gestört ist, eliminiert, d.h. die Abtastwertfolge kurz vor Beginn der Fehlerzeit wird mit der ungestörten Abtastwertfolge kurz nach Ende der Fehlerzeit fortgesetzt. Die ungestörten Signalabschnitte außerhalb der Fehlerzeiten werden also etwa um die Fehlerzeit zu einem lückenlosen Signal zusammengezogen.

Bei der erfindungsgemäßen Lösung wird also auf die Information des Signals während der Fehlerzeit vollkommen verzichtet. Dadurch ergibt sich kein Nachteil gegenüber bekannten Schaltungen, weil das Signal während der Fehlerzeit ohnehin gestört ist und bei der Wiedergabe meist Störgeräusche verursachen würde. Die Eliminierung der Fehlerzeit, d. h. die zeitliche Zusammenschiebung der Signale verändert die Zeitbasis der gesamten Tondarbietung; denn diese wird etwa um die Summe aller Fehlerzeiten verkürzt. In der Praxis hat sich gezeigt, daß eine zeitliche Verkürzung einer Tondarbietung um bis zu 5% nicht störend in Erscheinung treten muß. Das lückenlose Zusammenziehen von Signalteilen wird oft auch über einen längeren Zeitraum vom menschlichen Ohr nicht wahrgenommen. Die Wahrnehmbarkeit solcher Zusammenziehungen und die hiermit verbundene Störwirkung ist auf jeden Fall geringer als bei einer bekannten Stummschaltung, bei der jeweils das Signal während der Fehlerzeit ausgetastet ist. Die erfindungsgemäße Lösung ermöglicht die Überbrückung auch längerer Fehlerzeiten. Die Toleranzschwelle des Benutzers gegenüber Fehlern und Verschleiß von Aufzeichnungsträgern mit digitaler Tonaufzeichnung wird größer, da unkorrigierbare Fehler des digitalen Signals, insbesondere des PCM-Tonsignals, nicht zu einer bei Austastungen unmittelbar als inakzeptabel empfundenen Signalqualität führen. Dadurch kann bei Anwendung der Erfindung ein nicht verschleißfreier Aufzeichnungsträger, wie z. B. ein Magnetband, bei allmählich ansteigender Häufigkeit von Burstsfehlern länger ohne wahrnehmbar oder merklich störende Effeke bei der Wiedergabe verwendet werden.

Ein weiterer Vorteil der Erfindung besteht darin, daß bei jedem Fehler nur eine Adressen-Umschaltung für das Abrufen der Abtastwerte aus einem Zwischenspeicher erforderlich ist, nämlich von der Signaladresse kurz vor der Fehlerzeit auf die entsprechende Signaladresse nach der Fehlerzeit.

Gemäß einer Weiterbildung der Erfindung wird das Signal laufend einer Analyseschaltung zugeführt. Diese ermittelt, ob es sich jeweils um einen periodischen oder um einen nichtperiodischen (regellosen) Signalabschnitt handelt. Eine solche Analyseschaltung enthält vorzugsweise einen sogenannten Pitch-Detektor, z. B. nach der AMDF-Methode (vgl. Beschreibung « Average Magnitude Difference Funktion Pitch Extractor » von Myron J.Ross et al. auf den Seiten 353 bis 362 in « IEEE Transactions on Acoustics, Speech, and Signal Processing », Bd. ASSP-22, Nr. 5, Oktober 1974).

Während eines nichtperiodischen und damit regellosen und rauschartigen Signalabschnittes ist in dem Signal keine Periodendauer erkennbar. Bei einem solchen Signal kann der erste fehlerhafte Abtastwert durch den nächsten nicht gestörten Abtastwert ersetzt werden, so daß alle Abtastwerte nach dem Fehler exakt um die Anzahl der fehlerhaften Abtastwerte, d. h. um die Dauer des Fehlers verschoben sind. Der Übergang zwischen den Signalabschnitten vor und nach der Fehlerzeit erfolgt vorzugsweise an Nullstellen des Signals, wobei die Nulldurchgänge der beiden Signale gleiche Nulldurchgangsrichtung aufweisen. Dadurch wird ein idealer Übergang ohne Sprungstellen und dadurch bedingte hörbare Störungen erreicht. Bei einem periodischen oder stimmhaften Signal ist in dem Signal eine Periodendauer erkennbar. Bei einem solchen Signal erfolgt zusätzlich zu den Bedingungen bei einem nichtperiodischen Signal der Abbruch des Signals vor der Fehlerzeit und der Einsatz des Signals nach der Fehlerzeit an der gleichen Stelle relativ zum jeweiligen Anfang einer Periode. Das bedeutet, daß das Zeitintervall, um den die Abtastwertfolgen vor und nach dem Fehler zeitlich zusammengezogen werden, gleich einem ganzzahligen Vielfachen der Periodendauer ist.

Zur Unterscheidung der beiden genannten Fälle ist eine Logik vorgesehen, die entscheidet, ob es sich beim gestörten Signalteil um ein periodisches oder nichtperiodisches Signal handelt. In Abhängigkeit davon wird das Maß der zeitlichen Zusammenziehung und damit die Ausblendlänge in dem Signal gesteuert. Für diese Entscheidung wird das gestörte Signal vor und nach der Störung herangezogen. Es werden dabei die Anzahl der Signal-Nulldurchgänge, die Amplitude des Signals und die Ergebnisse einer Differenzkorrelation DKF eines tiefpaßgefilterten Signals mit einem Pitch-Detektor ausgewertet. Anstelle einer DKF kann auch eine Autokorrelation AKF verwendet werden.

Für die erfindungsgemäße Lösung wird eine zeitliche Vorziehung des ungestörten Signals nach der Fehlerzeit vorgesehen; ein derartiger zeitlicher Vorgriff auf ein an sich erst später kommendes Signal ist bei der digitalen Übertragungstechnik möglich, wenn die digitalen Signale zunächst in einem Pufferspeicher eingelesen werden. Mit diesem Speicher ist es möglich, bei einer Störung zur Realisierung der Erfindung ohne Verzögerung auf Signal-Abtastwerte überzugehen, die an sich etwa um die Dauer der Fehlerzeit erst später liegen. In Abhängigkeit vom Speicherfüllzustand kann der Speicher nach dem erfindungsgemäßen Überspringen eines Adressbereiches durch Änderung des Einlesetaktes aufgefüllt werden. Die Erfindung ist sowohl bei Aufzeichnungsgeräten mit steuerbarem Einlesetakt als auch für Übertragungsverfahren mit festem Einlesetakt einsetzbar. Um im letzteren Fall den Zwischenspeicher wieder zu füllen, kann das ungestörte Signal um die Fehlerlänge gedehnt werden oder ein Signalteil vor oder nach dem Burstfehler wiederholt werden.

Die Erfirdung wird im folgenden anhand der Zeichunung erläutert. Darin zeigen:
Fig. 1 Zeitverläufe eines periodischen Signals;
Fig. 2 Zeitverläufe eines nichtperiodischen Signals, und
Fig. 3 ein Blockschaltbild zur Durchführung des Verfahrens nach Fig. 1 oder 2;
Fig. 4 ein Blockschaltbild für das Verfahren bei drahtloser Übertragung;
Fig. 5 Datenvorlauf über der Zeit.

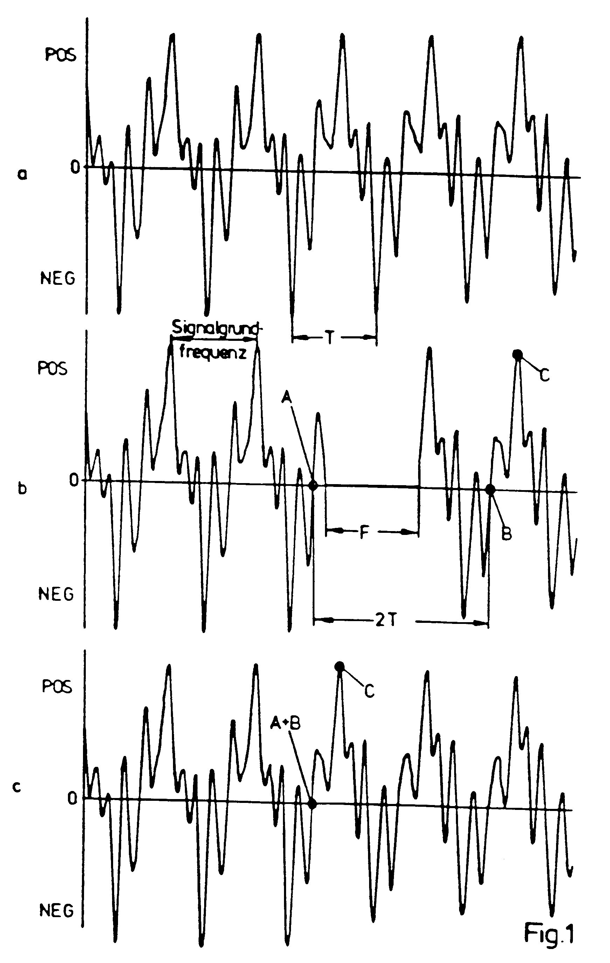

Fig. 1a zeigt ein ungestörtes, analoges, periodisches Audiosignal mit der Periodendauer T. Ein solches Signal kann in einerAnaiyseschaitung mit einem Pitch-Detektor als periodisches Signal erkannt werden.

Fig. 1b zeigt das Signal gemäß Fig. 1a mit einer Störung während einer Fehlerzeit F. In Fig. 1 b ist angenommen, daß das Signal während der Fehlerzeit F stummgeschaltet ist.

Gemäß Fig. 1c wird die Auswertung des Signals vor der Fehlerzeit F im Punkt A unterbrochen. Der Punkt A markiert die letzte eindeutige Nullstelle des Signals vor der Fehlerzeit F. Gleichzeitig wird die Signalfolge mit dem Punkt B des Signals nach der Fehlerzeit F fortgesetzt. Der Punkt B hat dabei innerhalb der Periode T die gleiche Lage wie der Punkt A. Die Punkte A und B in Fig. 1 b haben den Abstand der doppelten Periodendauer T. Der Abtastwert nach einer Periodendauer nach dem Punkt A kann nicht ausgewertet werden, weil hier die Fehlerzeit F noch andauert. Das Signal nach der Fehlerzeit F mit den Punkten B und C wird also um die Zeit 2T zeitlich vorgezogen und lückenlos an das Signal vor der Fehlerzeit F angefügt. Dadurch entsteht das lückenlose, keine fehlerhaften Abtastwerte enthaltende Signal gemäß Fig. 1c, in dem sowohl der Signalanteil als auch die Zeit zwischen A und B in Fig. 1 b eliminiert sind.

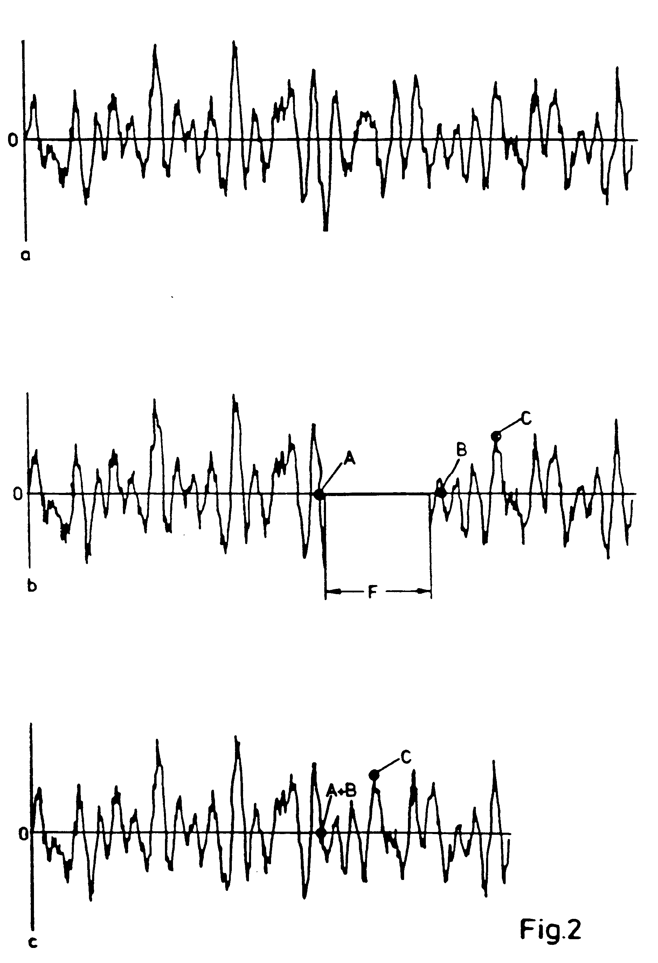

Fig. 2 zeigt die Wirkungsweise für ein nichtperiodisches Signal. In dem Signal gemäß Fig. 2a ist weder visuell noch bei einer automatischen Pitchanalyse eine Periodendauer erkennbar. Der Punkt A in Fig. 2b liegt wieder bei der letzten eindeutigen Nullstelle des Signals vor der Fehlerzeit F. Der Punkt B liegt bei der ersten eindeutigen Nullstelle des Signals nach der Fehlerzeit F mit der gleichen Nulldurchgangsrichtung wie im Signal am Punkt A. Im Gegensatz zu Fig. 1 kann hier keine Periodendauer ausgewertet werden. Gemäß Fig. 2c wird im Punkt A wiederum das Signal mit dem Punkt B fortgesetzt. Das Signal nach der Fehlerzeit F wird also wieder um die Zeit von A bis B zeitlich vorgezogen und lückenlos an das Signal vor der Fehlerzeit B angefügt. Der Punkt C ist dabei wieder ein willkürlich gewählter Punkt im Signal nach der Fehlerzeit F, der nur die zeitliche Verschiebung des Signals nach der Fehlerzeit F andeuten soll.

Bei der Verarbeitung von mehreren zeitlich kohärenten Signalen, z. B. zwei Stereo-Tonsignalen, darf eine zeitliche Zusammenziehung, die eventuell nur in einem der beiden Signale notwendig ist, keinesfalls zu einer andauernden zeitlichen Verschiebung der beiden Signale gegeneinander führen. Zur Vermeidung von so verursachten Laufzeitfehlern muß eine in einem Signal erforderlichen Signalzusammenziehung innerhalb einer vergleichsweise geringen Zeit auch zu einer gleichlangen, den Zeitversatz kompensierenden Zusammenziehung im anderen Signal führen. Diese kompensatorische Zusammenziehung im nicht betroffenen Signal wird zweckmäßigerweise in einem nichtperiodischen Abschnitt dieses Signales erfolgen.

Die Bearbeitung der Signale wurde in den Fig. 1, 2 zur Vereinfachung anhand analoger Signale erläutert. Die beschriebene Behandlung der Signale erfolgt jedoch im digitalen Signalweg, so daß z.B. im Punkt Adas letzte Datenwort des Signals vor der Fehlerzeit F etwa mit dem analogen Wert Null und das erste Datenwort des Signals nach der Fehlerzeit, also vom Punkt B, mit dem ersten dem analogen Wert Null folgenden Abtastwert zeitlich aufeinanderfolgen.

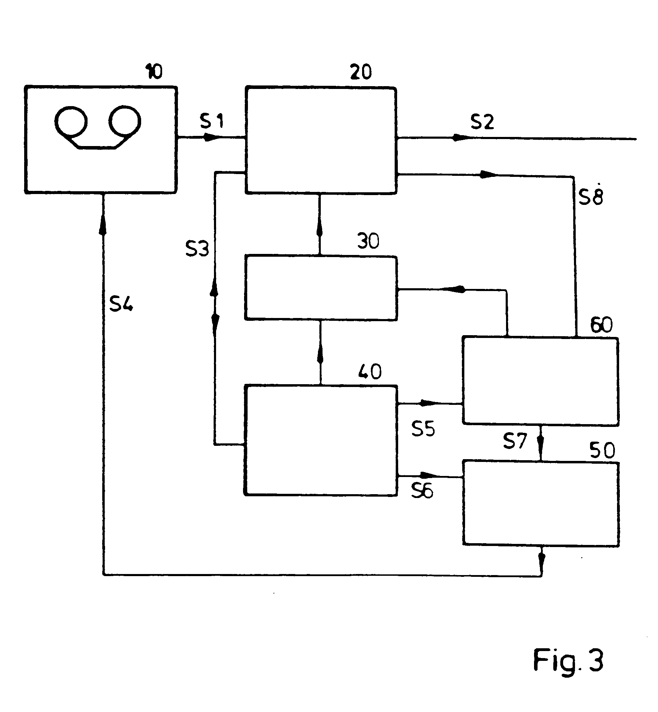

Fig. 3 zeigt ein mögliches Blockschaltbild zur Realisierung eines Audio-PCM-Magnetbandgerätes. Vom Laufwerk 10 gelangen die Daten über die Leitung S1 in den Datenpufferspeicher 20. Mit Hilfe der Fehlerkorrektur-/De-Interleavingstufe 40 und der Adressen-Steuerung 30 werden die Daten in zeitlich richtiger Folge am Ausgang S2 bereitgestellt. Eine Datenmengensteuerung 50 sorgt für entsprechende Bandvorschubregelung über die Leitung S4 permanent für einen ausreichenden Füllstand des Pufferspeichers 20. Gelangen nun über einen längeren Zeitraum fehlerhafte Daten in den Pufferspeicher 20, so daß das Fehlerkorrektursystem 40 versagen muß, so wird über S5 eine entsprechende Information an die Burstfehlerkorrektur-Schaltung 60 übertragen. Diese Schaltung steuert in Abhängigkeit von einer Signalanalyse, die ebenfalls im Block 60 erfolgt, die Adressen-Steuerung 30, so daß der gestörte Signalabschnitt nicht ausgegeben wird. Über die Datenmengen-Steuerung 50 wird der Pufferspeicher wieder aufgefüllt.

Das soweit beschriebene Verfahren kann überall dort zur Anwendung kommen, wo der Einlesetakt für die Datenmenge steuerbar ist (z.B. CD-Player, DAT).

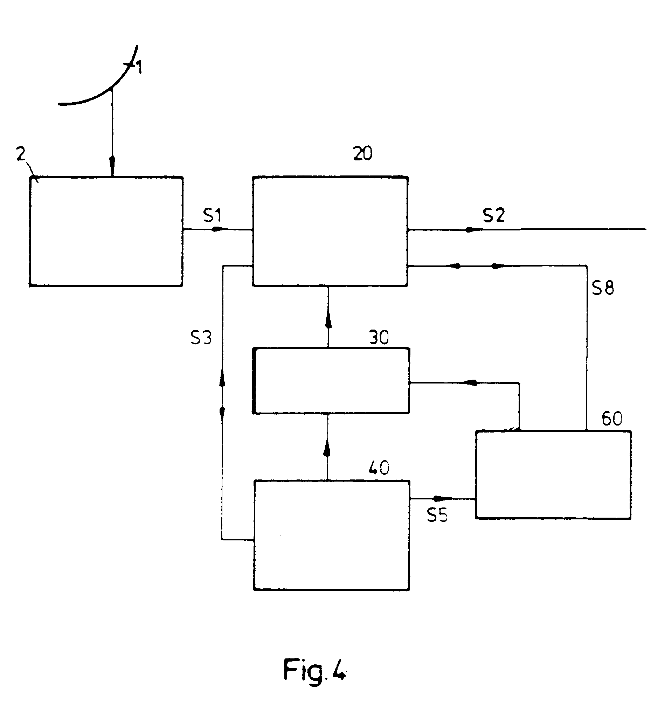

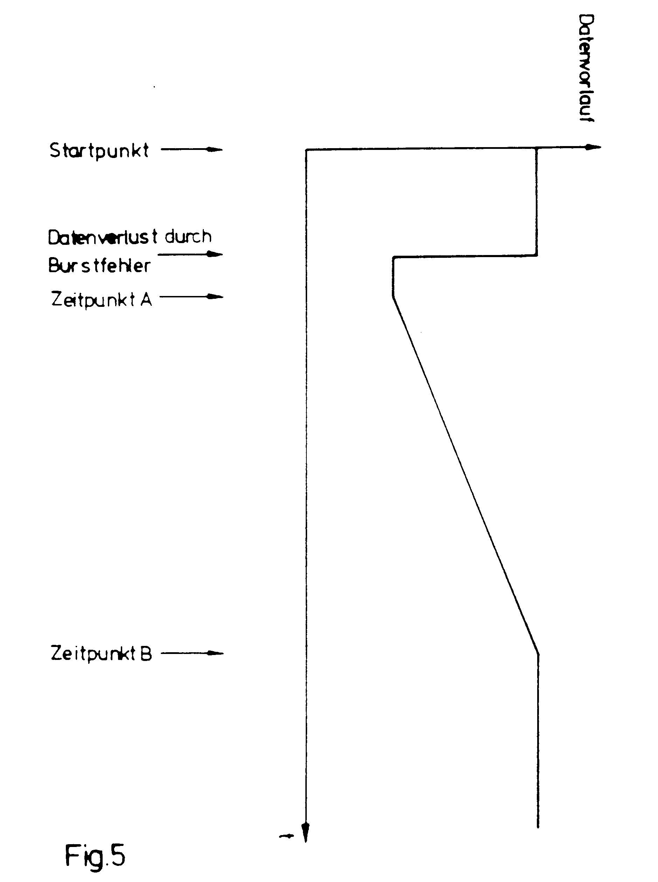

Fig. 4 zeigt ein Blockschaltbild für den Einsatz dieses Verfahrens auch bei Übertragungsverfahren mit festem Einlesetakt (z. B. Stelliten-Rundfunk, Broadcast). Hierbei ist eine Dehnung des ungestörten Signals um die Länge des eliminierten Signalteils in derZeitachse vorgesehen. Von einerAntenne 1 gelangen die digitalen Audio- und/oder Videosignale zu einem Empfangsgerät 2. Von dort gelangen die Daten über die Leitung S1 in den Datenpufferspeicher 20. Mit Hilfe der Fehlerkorrektur-/De-Interleavingstufe 40 und der Adresse-Steuerung 30 werden die Daten in zeitlich richtiger Folge am Ausgang S2 bereitgestellt. Gelangen nun über einen längeren Zeitraum fehlerhafte Daten in den Pufferspeicher 20, so daß das Fehlerkorrektursystem 40 versagen muß, so wird wie in Fig. 3 über S5 eine entsprechende Information an die Burstfehlerkorrektur-Schaltung 60 übertragen. Diese Schaltung steuert in Abhängigkeit von einer Signalanalyse, die ebenfalls im Block 60 erfolgt, die Agressen-Steuerung 30, so daß der gestörte Signalabschnitt nicht ausgegeben wird. Weil in Fig. 3 der Speicher 20 mit konstantem Takt ausgelesen wird, fehlen in der Schaltung nach Fig. 3 Teile des Signals. Um den Speicher 20 wieder zu füllen, detektiert die Schaltung 60 mit einem Pitch-Detektor einen nicht periodischen Signalverlauf nach dem Burstfehler. In diesem Signalteil beginnt dann die Dehnung des Signals in der Zeitachse, was einer Auslesetaktänderung bzw. einer Geschwindigkeitsänderung beim analog arbeitenden Kassettenrecorder entspricht. Das Signal ändert sich hierbei nur geringfügig in der Tonlage, so daß die Manipulation ohne Einfluß auf den Höreinbruch bleibt. Über die Leitung S5 wird der Schaltung 60 der Fehlerort und die Fehlerlänge übermittelt. In Abhängigkeit von dieser Information wird die Signaldehnung in Schaltung 60 derart gesteuert, daß das um den gestörten Abschnitt verminderte Signal in der gleichen Zeit ausgelesen wird, wie ein insgesamt ungestörtes Signal. Den zeitlichen Verlauf der Datenvorlaufmenge zeigt Fig. 5. Nach dem Einschalten hat der Datenspeicher 20 einen Datenmengenvorlauf und es würde keine Dehnung des Signals in der Zeitachse erfolgen. Tritt nun ein Burstfehler (Burstfehler < Datenvorlauf) auf und wird so der gestörte Signalabschnitt unter Eliminierung des gestörten Signalabschnittes zeitlich zu einem lükkenlosen Signal zusammengezogen, so würde ab Punkt A in Fig. 5 (Signal ist in diesem Punkt regellos) eine konstante Dehnung des Signales erfolgen. Die Größe und die Länge der Dehnung richtet sich nach der Burstfehlerlänge. Kommt der dadurch erzeugte « Datengewinn » in die Größenordnung des ursprünglichen Datenvorlaufs, so wird die Maßnahme an geeigneter Stelle (Punkt B) rückgängig gemacht. Dieser Vorgang wiederholt sich bei jedem weiteren Burstfehler.

Eine optimale Wirkung wird erzielt, wenn eine Wieder-Erhol-Zeit für das Signal gegeben ist. Versuche zeigen, daß selbst Burstfehler in Abständen von etwa 1 sec zu einem akzeptablen Fehlerausgleich führen. Es muß aber gewährleistet sein, daß zwischen Burstfehlern ein geeignet großer Datenvorlauf vorhanden ist.

Bei einer Variante des Blocks 60 der in Fig. 4 dargestellten Schaltung werden in den Signalabschnitten vor und nach dem Burstfehler Signalteile mit geringer Amplitude oder einem sehr geringen Energieinhalt (Signalpausen) detektiert. Die zeitliche Dehnung des Signals erfolgt dann durch Verlängerung der Signalpausen. Diese Möglichkeit eignet sich vorzugsweise für Sprachsignale.

Ist der Burstfehler nicht zu lang (<20 ms), so kann auch der Signalanteil vor oder nach dem Burstfehler wiederholt werden. Diese Wiederholung erlaubt einen kleineren Datenpufferspeicher als die Dehnung der Signalteile.

## Patentansprüche

1. Verfahren zur Verringerung der Wahrnehmbarkeit von burstartigen Fehlern in einem Audiosignal, bei dem während einer Fehlerzeit (F) eine mit anderen Mitteln (40) nicht korrigierbare Signalstörung auftritt, wobei im Sinne einer zeitlichen lückenlosen Zusammenziehung der ungestörten Signalabschnittevorund nach der Signalstörung jeweils die Signalwerte am Beginn (A) der Fehlerzeit (F) ohne zeitliche Unterbrechung mit den Signalwerten ab dem Ende (B) der Fehlerzeit (F) fortgesetzt werden, wobei die zeitliche Zusammenziehnung im digitalen Signalweg erfolgt, dadurch gekennzeichnet, daß eine zeitliche Vorverschiebung des Signals (B) nach der Fehlerzeit (F) auf einen Zeitpunkt (A) vor der Fehlerzeit (F) in einem Signalspeicher (20) durch seine Adressensteuerung (30) erfolgt, in den die digitale Abtastwertfolge bei der Signalwiedergabe, z.B. von einem Aufzeichnungsträger, eingelesen wird, und daß das dem Signalspeicher (20) entnommene Signal in Abschnitten vor oder nach dem gestörten Abschnitt in der Zeitachse etwa um die Länge des eliminierten Signalteils absolut gedehnt ist.

2. Verfahren nach Anspruch 1, dadurch gekennzeichnet, daß der Übergang zwischen den Signalabschnitten vor und nach der Fehlerzeit (F) an Nullstellen dieser Signale erfolgt.

3. Verfahren nach Anspruch 2, dadurch gekennzeichnet. daß die Nulldurchgänge der beiden Signale gleiche Nulldurchgangsrichtung, d.h. gleiches Vorzeichen der jeweiligen ersten Ableitung haben.

4. Verfahren nach Anspruch 1, dadurch gekennzeichnet, daß bei einem periodischen Signal (Fig. 1) das durch die zeitlichen Signalzusammenziehung ausgeblendete Signalzeitintervall in seiner Dauer gleich einem ganzzahligen Vielfachen der Periodendauer (T) des Signals vor oder nach der Signalstörung ist.

5. Verfahren nach Anspruch 1, dadurch gekennzeichnet, daß das Signal einer Analyseschaltung zugeführt wird, die den jeweiligen Zeitabschnitt auf Periodizitätprüftund in Abhängigkeit von dem Ergebnis die Art der Signalzusammenziehung steuert.

6. Verfahren nach Anspruch 5, dadurch gekennzeichnet, daß das Signal ein Tiefpaßfilter durchläuft, bevor es zum Detektor auf Periodizität gelangt.

7. Verfahren nach Anspruch 1, dadurch gekennzeichnet, daß bei mehreren zeitlich kohärenten Signalen, z.B. zwei Stereo-Tonsignalen, eine Anpassung der in einem Signal vorgenommenen Signalzusammenziehung durch eine zusätzliche etwa oder genau gleich lange Signalzusammenziehung an einem geeigneten Zeitpunkt im anderen Signal erfolgt.

8. Verfahren nach Anspruch 1, dadurch gekennzeichnet, daß bei zeitlich kohärenten Signalen, z.B. Bild- und Tonsignalen eines Videorecorders, durch Verlängerung der Signalpausen des Tonsignals eine Anpassung des zusammengezogenen Tonsignals an das Bildsignal erfolgt.

9. Verfahren nach Anspruch 8, dadurch gekennzeichnet, daß in den Signalabschnitten vor und/ oder nach dem gestörten Signalteil Signalpausen detektiert werden, und daß die zeitliche Dehnung des Signals durch Verlängerung der Signalpausen erfolgt.

10. Verfahren nach Anspruch 8, dadurch gekennzeichnet, daß die größte Dehnung in der Mitte des gedehnten Signalabschnittes vorgesehen ist und daß die Dehnungsdauer zum Anfang und zum Ende abnimmt.

11. Verfahren nach Anspruch 8 oder 10, dadurch gekennzeichnet, daß Signaldehnungen nur in regellosen Signalteilen beginnen und in demselben oder in einem anderen regellosen Signalteil enden.

12. Verfahren nach Anspruch 8, 10 oder 11, dadurch gekennzeichnet, daß in periodischen Signalteilen die Dehnung konstant ist oder nur geringe Änderung aufweist.

13. Verfahren nach einem der Ansprüche 9-12, dadurch gekennzeichnet, daß die Signaldehnung mechanisch durch Interpolation erfolgt.

14. Verfahren nach einem der Ansprüche 1-9, dadurch gekennzeichnet, daß an der Stelle des eliminierten Signalteils Signalteile vor oder nach dem Fehler wiederholt werden.

## Claims

1. A process of reducing the noticeability of burst- like errors in an audio signal, in which during an error time (F) there occurs a signal perturbation not correctable by other means (40), whereby in the sense of a time contraction without gaps of unperturbed signal sections before and after the signal perturbation, the signal values at the beginning (A) of the error time (F) are continued without time interruption with the signal values from the end (B) of the error time (F), whereby the time signal contraction occurs in the digital signals path, characterized in, that the there being effected a time pre-displacement of the signal (B) after the error time (F) to a moment (A) before the error time (F) in a signal memory (20) by its address control (30), in which the digital scanning value sequence is read in during signal reproduction, for example from a record carrier, and that the signal taken from the signal store is extended absolute to the signal entered into the signal store (20) in sections before or after the perturbed section in the time axis by approximately the length of the eliminated signal portions.

2. A process as claimed in claim 1, characterised in that the transition between the signal sections before and after the error time (F) occurs at zero points of these signals.

3. A process as claimed in claim 2, characterised in that the zero passages of the two signals have the same zero passage direction, that is the same sign for the first derivative.

4. A process as claimed in claim 1, characterised in that if the signal is periodic (fig. 1) the time interval of the signal which is blanked by the time signal contraction has a length that is equal to an integral multiple of the cycle duration (T) of the signal before or after the signal perturbation.

5. A process as claimed in claim 1, characterised in that the signal is supplied to an analysis circuit which checks the time section for periodicity and as a function of the result controls the signal contraction.

6. A process as claimed in claim 5, characterised in that the signal passes through a low-pass filter before it reaches the detector which detects periodicity.

7. A process as claimed in claim 1, characterised in that if there are a number of time coherent signals, for example two stereo sound signals, there occurs a matching of the signal contraction effected in the one signal by way of an additional signal contraction of the same or approximately the same length at a suitable point in time in the other signal.

8. A process as claimed in claim 1, charactarised in that if there are time coherent signals, for example picture and sound signals of a video recorder, there occurs a matching of the contracted sound signal to the picture signal by way of lengthening the signal pauses of the sound signal.

9. A process as claimed in claim 8, characterised in that signal pauses are detected in the signal sections before and/or after the perturbed signal sections before and/or after the perturbed signal portion and that the time extension of the signal is effected by lengthening the signal pauses.

10. A process as claimed in claim 8, characterised in that the greatest extension is provided in the centre of the extended signal section, and that the extension duration is reduced at the beginning and the end.

11. A process as claimed in claim 8 or claim 10, characterised in that signal extensions begin only in stochastic signal portions and end in the same or in another stochastic signal portion.

12. A process as claimed in claim 8, 10 or 11, characterised in that in periodic signal portions the extension is constant or only has a slight alteration.

13. A process as claimed in any one of claims 9 to 12, characterised in that the signal extension occurs mechanically through interpolation.

14. A process as claimed in any of the claims 1 to 9, characterised in that at the place of the eliminated signal portion there is a repetition of signal portions before or after the error.

## Revendications

1. Procédé pour réduire la perceptibilité de défauts en forme de salves dans un signal audio, dans lequel une perturbation du signal, qui ne peut pas être corrigée avec d'autres moyens, apparait pendant un intervalle de temps (F) d'apparition du défaut, et selon lequel, en vue d'obtenir une réunion par contraction dans le temps, sans aucun intervalle vide, des sections non perturbées du signal en amont et en aval de la perturbation du signal, on fait suivre les valeurs respectives du signal obtenu au début (A) de l'intervalle de temps (F) d'apparition du défaut, sans aucune interruption dans le temps, par les valeurs du signal obtenu à partir de la fin (B) de l'intervalle de temps (F) d'apparition du défaut, la réunion par contraction temporelle du signal s'effectuant dans la voie de transmission numérique du signal, caractérisé par le fait qu'une avance dans le temps du signal (B) présent après l'intervalle de temps (F) d'application du défaut, jusqu'à un instant (A) présent dans l'intervalle de temps (F) d'apparition du défaut s'effectue à l'aide d'une mémoire du signal (20) par la commande d'adresses (30) de ladite mémoire et dans laquelle la suite numérique de valeurs d'échantillonage est enregistrée lors de la lecture des signaux, par exemple à partir d'un support d'enregistrement, et que le signal prélevé de la mémoire du signal est dilaté absolument suivant l'axe des temps, d'une valeur correspondant approximativement à la longueur de la partie éliminée du signal, dans des sections situées en amont ou en aval de la section perturbée.

2. Procédé suivant la revendication 1, caractérisé par le fait que la jonction entre les sections du signal située en amont et en aval de l'intervalle de temps (F) d'apparition du défaut est réalisée au niveau de points d'annulation de ces signaux.

3. Procédé suivant la revendication 2, caractérisé par le fait qu'au niveau du point d'annulation des deux signaux, on a le même sens d'annulation, c'est-à-dire le même signe de la dérivée première respective.

4. Procédé suivant la revendication 1, caractérisé par le fait que dans le cas d'un signal périodique (fig. 1), l'intervalle de temps du signal, qui est supprimé par la réunion du signal par compression temporelle, possède une durée égale à un multiple entier de la durée de la période (T) du signal en amont ou en aval de la perturbation de ce signal.

5. Procédé suivant la revendication 1, caractérisé par le fait que le signal est envoyé à un circuit d'analyse, qui contrôle la périodicité de la section temporelle respective et commande le type de réunion du signal par contraction, en fonction du résultat.

6. Procédé suivant la revendication 5, caractérisé par le fait que le signal traverse un filtre passebas avant de parvenir au détecteur de la périodicité.

7. Procédé selon la revendication 1, caractérisé par le fait que dans le cas de plusieurs signaux cohérents dans le temps, par exemple dans le cas de deux signaux stéréophoniques, une adaptation de la réunion par contraction exécutée pour un signal est réalisée au moyen d'une contraction supplémentaire, d'une durée approximativement ou exactement identique, dans l'autre signal, à un instant approprié.

8. Procédé suivant la revendication 1, caractérisé par le fait que dans le cas de signaux cohérents dans le temps, par exemple dans le cas de signaux d'image et de signaux sonores d'un enregistreur vidéo, une adaptation du signal sonore contracté au signal d'image est réalisée au moyen d'un allongement des pauses dans le signal sonore.

9. Procédé suivant la revendication 8, caractérisé par le fait que dans les sections du signal situées en amont et/ou en aval de la partie perturbée du signal, on détecte des pauses dans le signal et qu'on réalise la dilatation temporelle du signal au moyen d'un allongement des pauses dans le signal.

10. Procédé suivant la revendication 8, caractérisé par le fait que la dilatation maximale est prévue au centre de la section dilatée du signal et que la durée de dilatation décroît vers le début et vers la fin.

11. Procédé suivant la revendication 8 ou 10, caractérisé par le fait que des dilatations du signal commencent uniquement dans des parties irrégulières du signal et se terminent dans ces mêmes parties ou bien dans une autre partie irrégulière du signal.

12. Procédé suivant la revendication 8, 10 ou 11, caractérisé par le fait que dans des parties périodiques du signal, la dilatation est constante ou bien ne présente qu'une légère modification.

13. Procédé suivant l'une des revendications 9-12, caractérisé par le fait que la dilatation du signal est réalisée mécaniquement par interpolation.

14. Procédé suivant l'une des revendications 1-9, caractérisé par le fait que des parties du signal situées en amont ou en aval du défaut sont répétées à la place de la partie éliminée du signal.
